# EUROPEAN PATENT SPECIFICATION

(11) **EP 3 627 548 B1**
(45) Date of publication and mention of the grant of the patent: **15.06.2022**
(21) Application number: 18831110.4
(22) Date of filing: 16.03.2018
(51) Int. Cl.: H01L 23/40, H01L 23/29, H01L 23/31, H01L 25/07, H01L 25/18, H01L 23/373, H01L 23/433, H01L 23/051

(54) **SEMICONDUCTOR MODULE AND METHOD FOR MANUFACTURING SEMICONDUCTOR MODULE**
HALBLEITERMODUL UND VERFAHREN ZUR HERSTELLUNG DES HALBLEITERMODULS
MODULE SEMI-CONDUCTEUR ET PROCÉDÉ DE FABRICATION DE MODULE SEMI-CONDUCTEUR

(30) Priority: 11.07.2017 JP 2017135137
(43) Date of publication of application: 25.03.2020
(73) Proprietor: Hitachi, Ltd., Tokyo 100-8280 (JP)
(72) Inventor: SUZUKI, Tomohisa, Tokyo 100-8280 (JP); YASUDA, Yuusuke, Tokyo 100-8280 (JP)
(74) Representative: Manitz Finsterwald Patent- und Rechtsanwaltspartnerschaft mbB
(86) International application number: PCT/JP2018/010553
(87) International publication number: WO 2019/012738

(56) References cited:
- WO-A1-2015/012188
- WO-A1-2015/104954
- WO-A1-2017/037837
- JP-A- H1 050 904
- JP-A- 2003 124 406
- JP-A- 2005 209 784
- JP-A- 2014 192 518
- JP-A- 2015 122 429
- JP-A- 2017 084 850
- US-A1- 2013 050 947
- US-A1- 2014 151 009

## Description

### Technical Field

The present invention relates to a semiconductor module and a method for manufacturing a semiconductor module.

### Background Art

In recent years, the market for power modules used in power control devices such as inverters has been expanding mainly in hybrid vehicles and railway applications. Against the backdrop of increased awareness of environmental protection and energy saving, the power modules are required to have higher efficiency. However, the performance of the conventional power modules using silicon (Si) is approaching their limits, and the next-generation power modules using more efficient silicon carbide (SiC) are being developed. The SiC power module can operate at a high temperature of 200°C or more, and has the advantage of being able to achieve a significant reduction in size and weight.

In a high temperature environment of 200°C or more, lead-free solder that has been used as the conventional chip bonding material cannot be used due to remelting problems. In addition, high melting point solder with a lead content of 85% or more, which is currently excluded from the Restriction of Hazardous Substances (RoHS) Directive, may become a target of the RoHS in the future, and the development of alternative materials is urgently needed. As these alternative materials, sintered metal material obtained by sintering metal particles of nanometer or micrometer order is expected, and the development is proceeding with respect to joining using sintered silver or sintered copper. For example, as shown in JP 2016-169411 A, a bonding layer made of sintered metal has a porous structure including pores therein.

For example, as shown in JP 2011-077464 A, a power module generally has a structure in which electrodes are connected to an Si chip using bonding material and a periphery thereof is sealed with mold resin. US 2013/0050947 A1 discloses a structure in which elastically deformable spring members are provided at upper and lower positions of a semiconductor element in order to realize sizing management of a power module filled with mold resin.

### Summary of Invention

### Technical Problem

As in JP 2011-077464 A and US 2013/0050947 A1, when the bonding with sintered metal is performed in the structure in which the periphery thereof is sealed with the mold resin and the power module is operated, members around the semiconductor element are thermally expanded due to the heat generated by the semiconductor element, and thereby compressive stress is generated. Due to the compressive stress and the heat at this time, the pores inside a sintered metal layer are collapsed and sintering proceeds, the sintered metal layer becomes dense, and accordingly, a thickness of the sintered metal layer is reduced from the initial state. When the power module is cooled from this state, the sintered metal layer tends to shrink more than the initial state. However, when the periphery is sealed with the mold resin, deformation in a thickness direction is constrained. Therefore, tensile stress is generated at an interface between the sintered metal layer and the semiconductor element. This tensile stress causes a new problem not found in the conventional solder material that the peeling occurs at the interface between the semiconductor element and the sintered metal layer. In order to solve this problem, it is necessary for the semiconductor element to follow the thickness change of the sintered metal layer.

In US 2013/0050947 A1, the elastically deformable spring members are provided at the upper and lower positions of the chip. However, because the periphery of the spring members is sealed with the relatively highly elastic mold resin, it may not be possible to sufficiently follow the thickness change of the sintered metal layer in operation.

JP 2017- 084850 A discloses a semiconductor module according to the preamble of claim 1. A semiconductor using a bonding structure having nano structures is disclosed in WO 2015/012188 A1.

### Solution to Problem

In order to solve the above problem, one of representative semiconductor modules of the present invention is achieved by including: a first cooling member; a semiconductor element provided above the first cooling member with a first bonding layer interposed between the semiconductor element and the first cooling member; a pressing member provided above the semiconductor element with a second bonding layer interposed between the pressing member and the semiconductor element; and a first sealing material provided above the first cooling member and sealing a region positioned in a side surface direction of the semiconductor element and the pressing member. In the semiconductor module, the pressing member is constituted of a first block member having a tray shape, a second block member provided above the first block member, and an elastic member and a second sealing material that are provided in a region between the first block member and the second block member.

### Advantageous Effects of Invention

According to the present invention, the semiconductor module can be realized in which the peeling can be suppressed at the interface of the semiconductor element and the bonding layer, the peeling occurring due to the sintered metal layer becoming dense at the time of semiconductor module operation.

### Brief Description of Drawings

[FIG. 1] FIG. 1 is a cross-sectional view of a semiconductor module according to an illustrative embodimment not falling under the scope of protection for which protection is sought.
[FIG. 2] FIG. 2 is a cross-sectional view of the semiconductor module according to the illustrative embodiment not falling under the scope of protection for which protection is sought.
[FIG. 3] FIG. 3 is a cross-sectional view of the semiconductor module according to the embodiment of the present invention.
[FIG. 4] FIG. 4 is a cross-sectional view of the semiconductor module according to the embodiment of the present invention.
[FIG. 5] FIG. 5 is a cross-sectional view of the semiconductor module according to illustrative embodiment not falling under the scope of protection for which protection is sought.
[FIG. 6] FIG. 6 is a diagram showing a method for manufacturing a semiconductor module according to the embodiment of the present invention.

### Description of Embodiment

Hereinafter, an embodiment according to the present invention is described in detail with reference to the drawings.

### Example 1

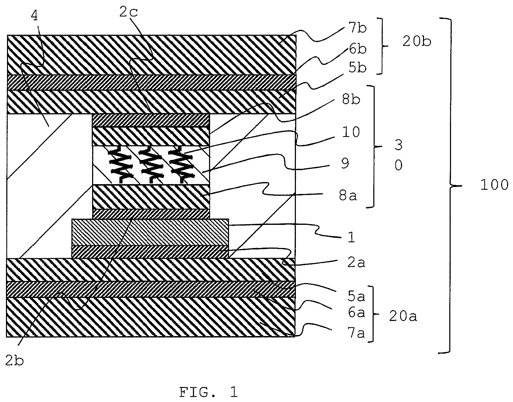

With reference to FIG. 1, a semiconductor module of the present illustrative example not falling under the scope of protection for which protection is sought is described. FIG. 1 is a cross-sectional view of a main part of a double-sided cooling type semiconductor module, showing a wiring structure of a semiconductor element 1 mounted between upper and lower cooling layers 7a and 7b.

The semiconductor module 100 shown in the present example has a laminated structure that includes a first wiring layer 5a, a first bonding layer 2a, the semiconductor element 1, a second bonding layer 2b, a first block member 8a, spring members 10, and a second block member 8b, and a second wiring layer 5b. A second sealing material 9 is sealed between the first block member 8a and the second block member 8b. A pressing member 30 is constituted of the first block member 8a, the second sealing material 9, the spring members 10, and the second block member 8b. The cooling layer 7a is provided on a lower layer (outside) of the first wiring layer 5a with an insulating member 5a interposed therebetween. The cooling layer 7b is provided on an upper layer (outside) of the second wiring layer 5b with an insulating member 6b interposed therebetween. A first cooling member 20a is constituted of the first wiring layer 5a, the first insulating layer 6a, and the first cooling layer 7a, and a second cooling member 20b is constituted of the second wiring layer 5b, the second insulating layer 6b, and the second cooling layer 7b.

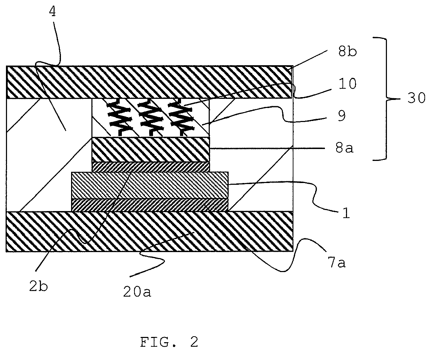

Note that the laminated structure is not limited to this, and for example, as shown in FIG. 2, a configuration of a single-sided cooling type semiconductor module may be used in which a third bonding layer 2c and the second cooling member 20b are not included.

The first wiring layer 5a, the second wiring layer 5b, the first block member 8a, and the second block member 8b are made of conductive material such as copper (Cu) or aluminum (Al). The first bonding layer 2a, the second bonding layer 2b, and the third bonding layer 2c are made of bonding material such as solder, sintered silver, sintered copper, and sintered gold, and at least one of the above layers is made of sintered metal bonding material such as sintered silver, sintered copper, and sintered gold. The semiconductor element 1 is made of semiconductor material such as Si, SiC, or gallium nitride (GaN). As a first sealing material 4, insulating material made of thermosetting resin such as epoxy resin and silica filler is generally used. The insulating members 6a and 6b are made of insulating material such as aluminum nitride (AlN), silicon nitride (SiN), aluminum oxide (Al₂O₃), and a resin sheet. The cooling layers 7a and 7b are made of material having high thermal conductivity such as Al and Cu.

In the case of operating the semiconductor module at high temperature, the semiconductor element 1 is preferably a wide band gap semiconductor such as SiC or GaN, and the bonding layer is preferably made of sintered silver or sintered copper having a high melting point and high heat resistance. Further, it is more preferable that the bonding layer be made of sintered copper, and the wiring layer and the block member be made of Cu, because a difference in coefficients of linear expansion between the members is eliminated and strain is reduced.

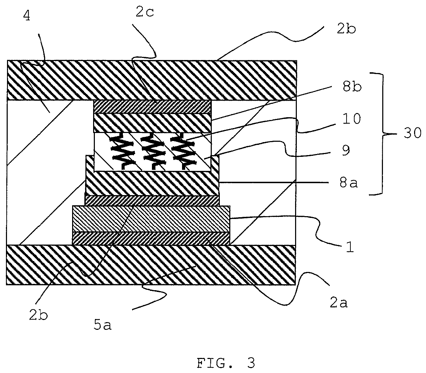

The spring member 10 is made of conductive metal material and has a structure that can expand in a laminating direction and greatly elastically deformed (zigzag shape, leaf spring shape, disc spring shape, spring shape, porous shape, sponge shape, honeycomb structure, or the like). These structures may be provided singularly or plurally. The spring may be a micro spring or nano spring. The second sealing material 9 is made of material different from at least that of the first sealing material 4. In this case, the second sealing material 9 is preferably made of material having a lower elastic modulus than that of the first sealing material 4. The second sealing material 9 is preferably made of material having lower rigidity in the thickness direction than that of the spring member 10 so as not to prevent the deformation of the spring member 10, the rigidity excluding the contribution of the spring member 10 when the second sealing material 9 is filled between the members 8a and 8b. As the second sealing material 9, for example, gel sealing material such as silicone gel is suitable. Further, in order to improve thermal conductivity and electrical conductivity, it is preferable to disperse conductive fine particles such as silver (Ag), nickel (Ni), carbon, or the like in the second sealing material 9, so that the fine particles are brought into contact with each other during compression and causes the electrical conductivity and thermal conductivity to be improved. Also, in the case of using highly fluid material such as silicone gel as a sealing material, the first block member 8a has a tray-shaped structure as shown in FIG. 3 to prevent outflow, thereby it is possible to prevent the outflow.

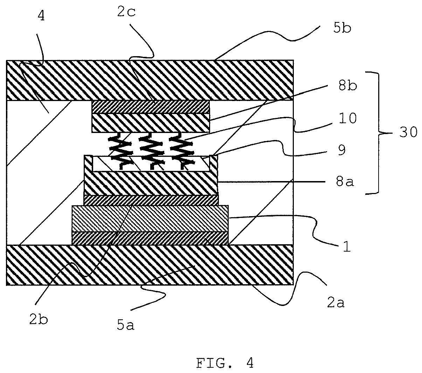

In addition, in the case in which the entire spring member is difficult to be sealed with the second sealing material 9, a reasonable effect can be obtained by only filling a lower region of the spring member 10 with the second sealing material 9 as shown in FIG. 4. In this case, an upper region of the spring member 10 is filled with the first sealing material 4.

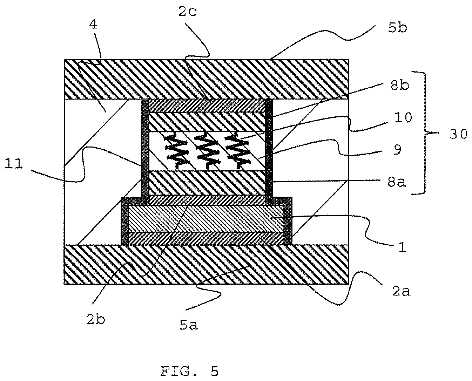

Further, as shown in FIG. 5, by providing a coating layer 11 having a lower rigidity than the first sealing material 4 and the spring member 10 around the semiconductor element 1 and the pressing member 30, the semiconductor element 1 becomes easier to follow the thickness change of the sintered metal layer. As the coating layer 11, thermoplastic resin material generally used as a coating agent for semiconductors can be used.

By adopting the above configuration, even when the sintered metal layer becomes dense during operation of the semiconductor module and the thickness of the sintered metal layer is reduced, because the spring member surrounded by the low elastic material can follow this change, the peeling at the interface between the semiconductor element 1 and the bonding layer can be suppressed. In addition, because the rigidity of an upper structure of the semiconductor element 1 is reduced, there is an effect of reducing the strain generated in the second bonding layer 2b. Further, because the compressive stress is always applied to the bonding layer, an effect of preventing the cracking of the bonding layer can be obtained.

### Example 2

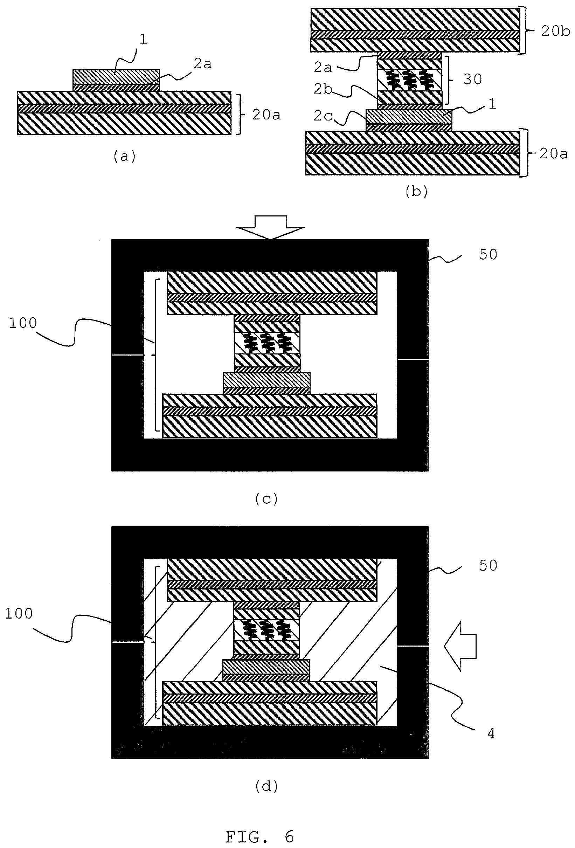

With reference to FIG. 1 and FIG. 6, a method for manufacturing a semiconductor module of the present embodiment is described.

FIGS. 1 and 6 show the case in which there is one semiconductor element, for convenience. However, plural semiconductor elements may be used. In addition, a detailed structure is omitted for convenience.

First, as shown in FIG. 6(a), the semiconductor element 1 is arranged on the first cooling member 20a with the first bonding layer 2a interposed therebetween. Next, as shown in FIG. 6(b), the pre-formed pressing member 30 is arranged on the semiconductor element 1 with the second bonding layer 2b interposed therebetween. The first bonding layer 2a and the second bonding layer 2b are made of sintered metal such as sintered silver, sintered copper, or sintered gold. Next, the second cooling member 20b is arranged on the pressing member 30 with the third bonding layer 2c interposed therebetween. The third bonding layer 2c is made of solder material, or sintered metal such as sintered silver, sintered copper, or sintered gold.

Next, as shown in FIG. 6(c), a mold 50 is arranged above and below the semiconductor module 100. At this time, a dimension in the height direction of the semiconductor module is set to be larger than an internal height dimension of the mold, and accordingly, the pressing member is compressed by pressure when the mold is clamped. In this state, the temperature is raised to a temperature necessary for the sintered metal to sinter, whereby sintering bonding is performed. After the sintering bonding is completed, as shown in FIG. 6(d), the conventional transfer molding process is performed to fill the mold with the first sealing material and perform thermosetting the first sealing material. By performing the above processes, when the sintered metal is used to perform the bonding, the pressure bonding can be achieved without using a dedicated pressurization apparatus, and thereby bonding strength of the sintered metal can be improved.

Here, the pre-formed pressing member 30 is constituted of the first block member, the second block member provided above the first block member, and the spring member and the sealing material provided in the region between the first block member and the second block member.

In addition, after the step of the sintering bonding and before the step of filling the first sealing material, there may be added a step of providing the coating layer having the rigidity lower than that of the first sealing material on the outside of the pressing member.

Note that the above-described examples have been specifically described in order to help understanding of the present invention.

### Reference Signs List

- 1: semiconductor element
- 2a: first bonding layer
- 2b: second bonding layer
- 2c: third bonding layer
- 4: first sealing material
- 5a: first wiring layer
- 5b: second wiring layer
- 6a: first insulating layer
- 6b: second insulating layer
- 7a: first cooling layer
- 7b: second cooling layer
- 8a: first block member
- 8b: second block member
- 9: second sealing material
- 10: spring member
- 11: coating layer
- 20a, 20b: cooling member
- 30: pressing member
- 50: mold
- 100: semiconductor module

## Claims

1. A semiconductor module (100), comprising:
a first cooling member (20a);
a semiconductor element (1) provided above the first cooling member (20a) with a first bonding layer (2a) interposed between the semiconductor element (1) and the first cooling member (20a);
a pressing member (30) provided above the semiconductor element (1) with a second bonding layer (2b) interposed between the pressing member (30) and the semiconductor element (1); and
a first sealing material (4) provided above the first cooling member (20a) and sealing a region positioned in a side surface direction of the semiconductor element (1) and the pressing member (30),
wherein the pressing member (30) comprises
a first block member (8a),
a second block member (8b) provided above the first block member (8a), and
a spring member (10) and a second sealing material (9) that are provided in a region between the first block member (8a) and the second block member (8b),
**characterized in that** the first block member (8a) has a tray shape.

2. The semiconductor module (100) according to claim 1, further comprising
a second cooling member (20b) provided above the pressing member (30) with a third bonding layer (2c) interposed between the second cooling member (20b) and the pressing member (30).

3. The semiconductor module (100) according to claim 1 or 2, wherein
the first sealing material (4) seals an upper region of the spring member (10), and
the second sealing material (9) seals a lower region of the spring member (10).

4. The semiconductor module (100) according to any one of claims 1 to 3, further comprising
a coating layer (11) having a rigidity lower than a rigidity of the first sealing material (4) between the pressing member (30) and the first sealing material (4).

5. The semiconductor module (100) according to any one of claims 1 to 4, wherein the second sealing material (9) is made of material having a lower elastic modulus than the first sealing material (4).

6. The semiconductor module (100) according to any one of claims 1 to 5, wherein the second sealing material (9) is made of gel sealing material.

7. The semiconductor module (100) according to any one of claims 1 to 6, wherein the second sealing material (9) is a material containing conductive fine particles.

8. The semiconductor module (100) according to any one of claims 1 to 7, wherein one of the first bonding layer (2a), the second bonding layer (2b), and the third bonding layer (2c) includes sintered metal obtained by sintering metal particles.

9. A method for manufacturing a semiconductor module (100), comprising the steps of:
arranging a semiconductor element (1) above a first cooling member (20a) with a first bonding layer (2a) interposed between the semiconductor element (1) and the first cooling member (20a);
arranging a pressing member (30) above the semiconductor element (1) with a second bonding layer (2b) interposed between the pressing member (30) and the semiconductor element (1);
applying pressure to the pressing member (30) by a mold (50), and
filling the mold (50) with a first sealing material (4),
wherein the pressing member (30) is constituted of
a first block member (8a),
a second block member (8b) provided above the first block member (8a), and
a spring member (10) and a sealing material that are provided in a region between the first block member (8a) and the second block member (8b),
**characterized by** sintering metal contained in the first bonding layer (2a) and the second bonding layer (2b) by heating, and in that the first block member (8a) has a tray shape.

10. The method for manufacturing a semiconductor module (100) according to claim 9, further comprising,
after the step of arranging the pressing member (30) and before the step of applying pressure to the pressing member (30),
a step of arranging a second cooling member (20b) above the pressing member (30) with a third bonding layer (2c) interposed between the second cooling member (20b) and the pressing member (30).

11. The method for manufacturing a semiconductor module (100) according to claim 9 or 10, further comprising,
after the step of sintering the metal and before the step of filling with the first sealing material (4),
a step of providing a coating layer (11) having a rigidity lower than a rigidity of the first sealing material (4) on a surface of the pressing member (30).

## Patentansprüche

1. Halbleitermodul (100), umfassend:
ein erstes Kühlelement (20a);
ein Halbleiterelement (1), das oberhalb des ersten Kühlelements (20a) vorgesehen ist, mit einer ersten Verbindungsschicht (2a), die zwischen dem Halbleiterelement (1) und dem ersten Kühlelement (20a) angeordnet ist;
ein Presselement (30), das über dem Halbleiterelement (1) vorgesehen ist, mit einer zweiten Verbindungsschicht (2b), die zwischen dem Presselement (30) und dem Halbleiterelement (1) angeordnet ist; und
ein erstes Dichtungsmaterial (4), das oberhalb des ersten Kühlelements (20a) vorgesehen ist und einen Bereich abdichtet, der in einer Seitenflächenrichtung des Halbleiterelements (1) und des Presselements (30) positioniert ist,
wobei das Presselement (30) umfasst:
ein erstes Blockelement (8a),
ein zweites Blockelement (8b), das oberhalb des ersten Blockelements (8a) vorgesehen ist, und
ein Federelement (10) und ein zweites Dichtungsmaterial (9), die in einem Bereich zwischen dem ersten Blockelement (8a) und dem zweiten Blockelement (8b) vorgesehen sind,
**dadurch gekennzeichnet, dass** das erste Blockelement (8a) die Form einer Schale hat.

2. Halbleitermodul (100) nach Anspruch 1,
das ferner umfasst:
ein zweites Kühlelement (20b), das oberhalb des Presselements (30) vorgesehen ist, mit einer dritten Verbindungsschicht (2c), die zwischen dem zweiten Kühlelement (20b) und dem Presselement (30) angeordnet ist.

3. Halbleitermodul (100) nach einem der Ansprüche 1 oder 2,
wobei
das erste Dichtungsmaterial (4) einen oberen Bereich des Federelements (10) abdichtet, und
das zweite Dichtungsmaterial (9) einen unteren Bereich des Federelements (10) abdichtet.

4. Halbleitermodul (100) nach einem der Ansprüche 1 bis 3, ferner umfassend eine Überzugsschicht (11) mit einer Steifigkeit, die geringer als die Steifigkeit des ersten Dichtungsmaterials (4) ist, zwischen dem Presselement (30) und dem ersten Dichtungsmaterial (4).

5. Halbleitermodul (100) nach einem der Ansprüche 1 bis 4,
wobei das zweite Dichtungsmaterial (9) aus einem Material mit einem niedrigeren Elastizitätsmodul als das erste Dichtungsmaterial (4) besteht.

6. Halbleitermodul (100) nach einem der Ansprüche 1 bis 5,
wobei das zweite Dichtungsmaterial (9) aus einem Gel-Dichtungsmaterial besteht.

7. Halbleitermodul (100) nach einem der Ansprüche 1 bis 6,
wobei das zweite Dichtungsmaterial (9) ein Material ist, das leitfähige feine Partikel enthält.

8. Halbleitermodul (100) nach einem der Ansprüche 1 bis 7,
wobei eine der ersten Verbindungsschicht (2a), der zweiten Verbindungsschicht (2b) und der dritten Verbindungsschicht (2c) gesintertes Metall enthält, das durch Sintern von Metallpartikel erhalten wurde.

9. Verfahren zur Herstellung eines Halbleitermoduls (100), umfassend die Schritte:
Anordnen eines Halbleiterelements (1) über einem ersten Kühlelement (20a) mit einer ersten Verbindungsschicht (2a), die zwischen dem Halbleiterelement (1) und dem ersten Kühlelement (20a) angeordnet ist;
Anordnen eines Presselement (30) über dem Halbleiterelement (1) mit einer zweiten Verbindungsschicht (2b), die zwischen dem Presselement (30) und dem Halbleiterelement (1) angeordnet ist;
Ausüben von Druck auf das Presselement (30) durch eine Form (50), und Füllen der Form (50) mit einem ersten Dichtungsmaterial (4),
wobei das Presselement (30) umfasst:
ein erstes Blockelement (8a),
ein zweites Blockelement (8b), das oberhalb des ersten Blockelements (8a) vorgesehen ist, und
ein Federelement (10) und ein Dichtungsmaterial, die in einem Bereich zwischen dem ersten Blockelement (8a) und dem zweiten Blockelement (8b) vorgesehen sind,
**dadurch gekennzeichnet, dass** das in der ersten Verbindungsschicht (2a) und der zweiten Verbindungsschicht (2b) enthaltene Metall durch Erhitzen gesintert wird, und dass das erste Blockelement (8a) eine Schalenform aufweist.

10. Verfahren zur Herstellung eines Halbleitermoduls (100) nach Anspruch 9, ferner umfassend:
nach dem Schritt zum Anordnen des Presselements (30) und vor dem Schritt zum Aufbringen von Druck auf das Presselement (30),
einen Schritt zum Anordnen eines zweiten Kühlelements (20b) oberhalb des Presselements (30) mit einer dritten Verbindungsschicht (2c), die zwischen dem zweiten Kühlelement (20b) und dem Presselement (30) angeordnet ist.

11. Verfahren zur Herstellung eines Halbleitermoduls (100) nach einem der Ansprüche 9 oder 10, ferner umfassend:
nach dem Schritt zum Sintern des Metalls und vor dem Schritt zum Füllen mit dem ersten Dichtungsmaterial (4),
einen Schritt zum Bereitstellen einer Überzugsschicht (11) mit einer geringeren Steifigkeit als die Steifigkeit des ersten Dichtungsmaterials (4) auf einer Fläche des Presselements (30).

## Revendications

1. Module semi-conducteur (100), comprenant :
un premier élément de refroidissement (20a) ;
un élément semi-conducteur (1) prévu au-dessus du premier élément de refroidissement (20a) avec une première couche de liaison (2a) interposée entre l'élément semi-conducteur (1) et le premier élément de refroidissement (20a) ;
un élément de pressage (30) prévu au-dessus de l'élément semi-conducteur (1) avec une deuxième couche de liaison (2b) interposée entre l'élément de pressage (30) et l'élément semi-conducteur (1) ; et
un premier matériau d'étanchéité (4) prévu au-dessus du premier élément de refroidissement (20a) et étanchant une région positionnée dans une direction de surface latérale de l'élément semi-conducteur (1) et de l'élément de pressage (30),
dans lequel l'élément de pressage (30) comprend
un premier élément formant bloc (8a),
un second élément formant bloc (8b) prévu au-dessus du premier élément formant bloc (8a), et
un élément formant ressort (10) et un second matériau d'étanchéité (9) qui sont prévus dans une région entre le premier élément formant bloc (8a) et le second élément formant bloc (8b),
**caractérisé en ce que** le premier élément formant bloc (8a) a une forme de plateau.

2. Module semi-conducteur (100) selon la revendication 1, comprenant en outre
un second élément de refroidissement (20b) prévu au-dessus de l'élément de pressage (30) avec une troisième couche de liaison (2c) interposée entre le second élément de refroidissement (20b) et l'élément de pressage (30).

3. Module semi-conducteur (100) selon la revendication 1 ou 2, dans lequel le premier matériau d'étanchéité (4) étanche une région supérieure de l'élément formant ressort (10), et
le second matériau d'étanchéité (9) étanche une région inférieure de l'élément formant ressort (10).

4. Module semi-conducteur (100) selon l'une quelconque des revendications1 à 3, comprenant en outre
une couche de revêtement (11) ayant une rigidité inférieure à une rigidité du premier matériau d'étanchéité (4) entre l'élément de pressage (30) et le premier matériau d'étanchéité (4).

5. Module semi-conducteur (100) selon l'une quelconque des revendications 1 à 4, dans lequel le second matériau d'étanchéité (9) est constitué d'un matériau ayant un module d'élasticité inférieur à celui du premier matériau d'étanchéité (4).

6. Module semi-conducteur (100) selon l'une quelconque des revendications 1 à 5, dans lequel le second matériau d'étanchéité (9) est constitué d'un matériau d'étanchéité en gel.

7. Module semi-conducteur (100) selon l'une quelconque des revendications 1 à 6, dans lequel le second matériau d'étanchéité (9) est un matériau contenant des particules fines conductrices.

8. Module semi-conducteur (100) selon l'une quelconque des revendications 1 à 7, dans lequel une couche parmi la première couche de liaison (2a), la deuxième couche de liaison (2b), et la troisième couche de liaison (2c) inclut un métal fritté obtenu par frittage de particules de métal.

9. Procédé de fabrication d'un module semi-conducteur (100), comprenant les étapes consistant à :
agencer un élément semi-conducteur (1) au-dessus d'un premier élément de refroidissement (20a) avec une première couche de liaison (2a) interposée entre l'élément semi-conducteur (1) et le premier élément de refroidissement (20a) ;
agencer un élément de pressage (30) au-dessus de l'élément semi-conducteur (1) avec une deuxième couche de liaison (2b) interposée entre l'élément de pressage (30) et l'élément semi-conducteur (1) ;
appliquer une pression sur l'élément de pressage (30) par l'intermédiaire d'un moule (50), et
remplir le moule (50) avec un premier matériau d'étanchéité (4),
dans lequel l'élément de pressage (30) est constitué
d'un premier élément formant bloc (8a),
d'un second élément formant bloc (8b) prévu au-dessus du premier élément formant bloc (8a), et
d'un élément formant ressort (10) et d'un matériau d'étanchéité qui sont prévus dans une région entre le premier élément formant bloc (8a) et le second élément formant bloc (8b),
**caractérisé par** un frittage d'un métal contenu dans la première couche de revêtement (2a) et la seconde couche de revêtement (2b) par chauffage, et en ce que le premier élément formant bloc (8a) a une forme de plateau.

10. Procédé de fabrication d'un module semi-conducteur (100) selon la revendication 9, comprenant en outre,
après l'étape d'agencement de l'élément de pressage (30) et avant l'étape d'application d'une pression sur l'élément de pressage (30),
une étape consistant à agencer un second élément de refroidissement (20b) au-dessus de l'élément de pressage (30) avec une troisième couche de revêtement (2c) interposée entre le second élément de refroidissement (20b) et l'élément de pressage (30).

11. Procédé de fabrication d'un module semi-conducteur (100) selon la revendication 9 ou 10, comprenant en outre,
après l'étape de frittage du métal et avant l'étape de remplissage avec le premier matériau d'étanchéité (4),
une étape consistant à fournir une couche de revêtement (11) ayant une rigidité inférieure à une rigidité du premier matériau d'étanchéité (4) sur une surface de l'élément de pressage (30).
